# EUROPEAN PATENT APPLICATION

(11) **EP 2 801 803 A1**
(43) Date of publication of application: **12.11.2014**
(21) Application number: 13807043.8
(22) Date of filing: 13.06.2013
(51) Int. Cl.: G01K 7/18, H01C 7/04

(54) **THIN FILM RESISTOR TEMPERATURE SENSOR AND METHOD FOR MANUFACTURING SAME**

(30) Priority: 21.06.2012 JP 2012139670
(71) Applicant: Tateyama Kagaku Industry Co., Ltd., Toyama-shi, Toyama 939-8058 (JP)
(72) Inventor: UEDA Yoji, Toyama-shi Toyama 939-8058 (JP); WAKABAYASHI Suguru, Toyama-shi Toyama 939-8058 (JP); KIZAWA Hiroshi, Toyama-shi Toyama 939-8058 (JP)
(74) Representative: Suèr, Steven Johannes
(86) International application number: PCT/JP2013/066296
(87) International publication number: WO 2013/191071

(57) **Abstract**

A thin film resistance element temperature sensor (10) having a simple configuration, high resistance to contaminants, high durability and high measurement accuracy. The sensor (10) includes a resistance element (12) formed by a platinum thin film on an insulating substrate (14), and a barrier layer (20) consisting of crystallized glass which covers the resistance element (12). The sensor (10) a protective film (22) which covers the barrier layer (20), and electrode pads (16) stacked on connecting ends (12a) at both ends of the resistance element (12). The barrier layer (20) consists of crystallized glass in which Al₂O₃ exists at a blending ratio of 35% by mass or greater, SiO₂ exists at a blending ratio of 10% by mass or greater to 25% by mass or less, and the blending ratio Al₂O₃ is greater than that of CaO or SrO. The barrier layer (20) is stacked to cover the resistance element (12) and a part of the electrode pads (16) on the side of the resistance element (12). The protective film (22) consists of Si-Ba-Al-Zr based glass ceramic and covers the barrier layer (20), electrode pads (16) and base ends of lead terminals (18) connected to the electrode pads (16).

## Description

### TECHNICAL FIELD

The present invention relates to a thin film resistance element temperature sensor equipped with, on a surface of an insulating substrate, a resistance film pattern as a resistance element for measuring a temperature. The present invention relates also to a method for producing the thin film resistance element temperature sensor.

### BACKGROUND ART

As a temperature sensor equipped with a resistance film pattern for measuring a temperature, there has conventionally been, for example, a temperature sensor of a structure disclosed in PTL 1. This temperature sensor is a temperature sensor that includes a resistance element of a platinum thin film on a surface of an electrical insulating substrate, and includes an intermediate layer for protecting a sensor portion of the platinum resistance element from damage and contamination. The intermediate layer is constituted by a single diffusion stop layer ceramic. The composition of the intermediate layer is constituted by, for example, an oxide selected from a group consisting of Al₂O_{3,} MgO and Ta₂O₅.

Further, as disclosed in PTL 2, a configuration in which a platinum resistance film pattern is covered with an intermediate layer consisting of an Al₂O₃ thin film, and a glass ceramic layer consisting of quartz glass ceramic or Al₂O₃ is combined on the thin film with quartz glass ceramic has been proposed. Further, a configuration in which a ceramic cover is stacked on the configuration described above has been proposed. Especially this glass ceramic consists of high purity quartz ceramic and a ceramic component.

### CITATION LIST

### PATENT LITERATURE

Patent Literature 1: Japanese Patent Application Laid-open No. 2000-81354
Patent Literature 2: Japanese Patent Application Laid-open No. 2009-85952

### SUMMARY OF THE INVENTION

### PROBLEMS TO BE SOLVED BY THE INVENTION

Some of the temperature sensors in which a resistance element pattern of a platinum thin film is used are, for example, exhaust gas temperature sensors for automobiles, used in severe environments. In such a severe environment, there has been a case in which contaminants, such as sulfur oxide and nitrogen oxide, included in the ambient air enter passing through the intermediate layers disclosed in PTL 1 and PTL 2 or other protective films and react with the resistance element to make a resistance value of the resistance element incorrect or, a case in which silicon of a sealant and platinum of the resistance element react to cause silicidation. Further, there has been a case in which, due to a sudden temperature change, a crack or the like is produced in the protective film and the intermediate layer, whereby the resistance element is exposed to a contaminant, and platinum of the resistance element and the contaminant react to make the resistance value incorrect.

The present invention has been made in view of the problems of the background art described above and an object thereof is to provide a thin film resistance element temperature sensor having a simple configuration, high resistance to contaminants, high durability and high measurement accuracy, and to provide a method for producing the same.

### MEANS FOR SOLVING THE PROBLEM

The present invention is a thin film resistance element temperature sensor, comprising: a resistance element formed by a platinum thin film on an insulating substrate; a barrier layer consisting of crystallized glass which covers the resistance element; a protective film which covers the barrier layer; and electrode pads stacked on connecting ends at both ends of the resistance element, wherein the barrier layer consists of crystallized glass in which Al₂O₃ exists at a blending ratio of 35% by mass or greater, SiO₂ exists at a blending ratio of 10% by mass or greater to 25% by mass or less, and the blending ratio Al₂O₃ is greater than that of CaO or SrO.

The blending ratio of Al₂O₃ in the barrier layer is preferably 35% by mass or greater to 50% by mass or less. The blending ratio of SiO₂ in the barrier layer is preferably 15% by mass or greater to 20% by mass or less.

The barrier layer is stacked to cover the resistance element and a part of the electrode pads on the side of the resistance element.

The barrier layer includes each oxide of Al₂O₃-ZnO-SiO₂-CaO-BaO. Alternatively, the barrier layer is a material including each oxide of Al₂O₃-ZnO-SiO₂-SrO-BaO.

The barrier layer includes spinel structure oxide of CaAl₂O₄ or SrAl₂O₄. Alternatively, the barrier layer includes spinel structure oxide of CaAl₂O₄ and SrAl₂O₄.

The protective film consists of Si-Ba-Al-Zr based glass ceramic and covers the barrier layer, the electrode pads and base ends of lead terminals connected to the electrode pads.

A mass ratio of each component of the Si-Ba-Al-Zr based glass ceramic of the protective film is about 5:2:1:1: (other components 1).

Further, the present invention is a method for producing a thin film resistance element temperature sensor, comprising: forming a resistance element by a platinum thin film on an insulating substrate; applying, to the resistance element, material paste of crystallized glass in which Al₂O₃ exists at a blending ratio of 35% by mass or greater, SiO₂ exists at a blending ratio of 10% by mass or greater to 25% by mass or less, and the blending ratio Al₂O₃ is greater than that of CaO or SrO, and then performing heat treatment; covering the resistance element with the crystallized glass to form a barrier layer; applying an electrode pad material to connecting ends of the resistance element and performing heat treatment to form electrode pads; connecting lead terminals to the electrode pads; and applying material paste of a protective film to cover the barrier layer and the electrode pads and performing heat treatment to form the protective film on the barrier layer.

Trimming is performed to adjust a resistance value of the resistance element before formation of the barrier layer. Alternatively, the barrier layer may be formed except for a trimming location of the resistance element and trimming may be performed to adjust a resistance value of the resistance element after formation of the barrier layer.

The lead terminals are connected to the electrode pads by welding, and a glass component of the barrier layer in an area near the lead terminals fuses with heat at the time of the welding and then solidifies to increase connection strength of that portion.

### EFFECT OF THE INVENTION

The thin film resistance element temperature sensor of the present invention reduces damage caused by entrance of contaminants in the ambient air and by a temperature change, eliminates a decrease in measurement accuracy, and enables accurate temperature measurement for a long period of time. Further, according to the method for producing the thin film resistance element temperature sensor of the present invention, a configuration of each layer is simple, production of the thin film resistance element temperature sensor is easy, and production cost can also be reduced.

### BRIEF DESCRIPTION OF THE DRAWINGS

Fig. 1 is a longitudinal cross sectional view of a thin film resistance element temperature sensor of an embodiment of the present invention.
Fig. 2 is an exploded longitudinal cross sectional view of the thin film resistance element temperature sensor of the present embodiment.
Fig. 3 is a plan view of the thin film resistance element temperature sensor of the present embodiment in a state in which a barrier layer is provided.
Fig. 4 is a plan view of the thin film resistance element temperature sensor of the present embodiment in a state in which a barrier layer and a lead terminal are provided.
Fig. 5 is a perspective view illustrating a production process of the thin film resistance element temperature sensor of the present embodiment.
Fig. 6A is a graph illustrating an amount of change with time of a resistance value of an example of a thin film resistance element temperature sensor of the present invention.
Fig. 6B is a graph illustrating an amount of change with time of a resistance value of a related art thin film resistance element temperature sensor.
Fig. 7A is a graph illustrating an amount of change with time of a resistance value in an example of a thin film resistance element temperature sensor of the present invention in a state in which a protective film is not provided.
Fig. 7B is a graph illustrating an amount of change with time of a resistance value in a related art thin film resistance element temperature sensor in a state in which a protective film is not provided.
Fig. 8 is a graph illustrating a blending ratio of SiO₂ in a barrier layer and an amount of change in a resistance value at 1000°C at 1000 hours of an example of a thin film resistance element temperature sensor of the present invention.
Fig. 9 is a graph illustrating an amount of change with time of a resistance value in accordance with a difference in a component composition of a barrier layer of an example of a thin film resistance element temperature sensor of the present invention.
Fig. 10 is a graph illustrating an amount of change with time of a resistance value in a case in which a spinel structure oxide is included in a barrier layer of an example of a thin film resistance element temperature sensor of the present invention.

### BEST MODES FOR CARRYING OUT THE INVENTION

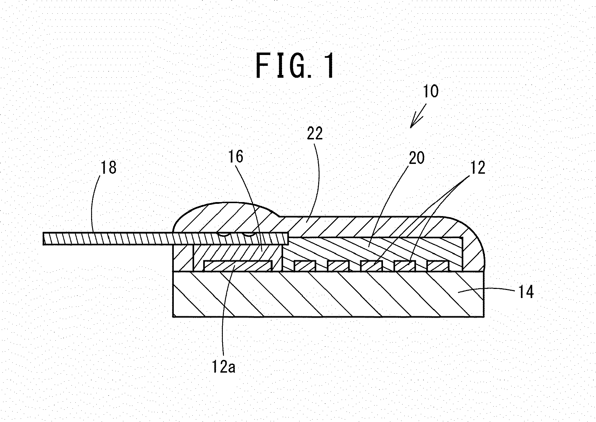

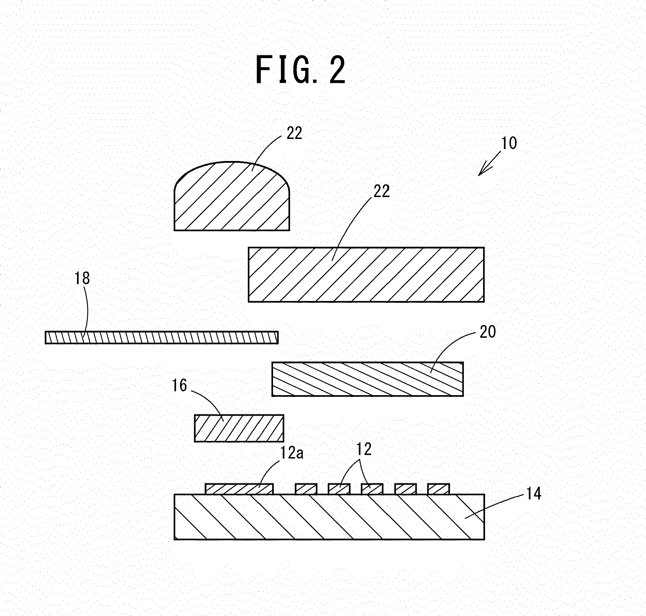

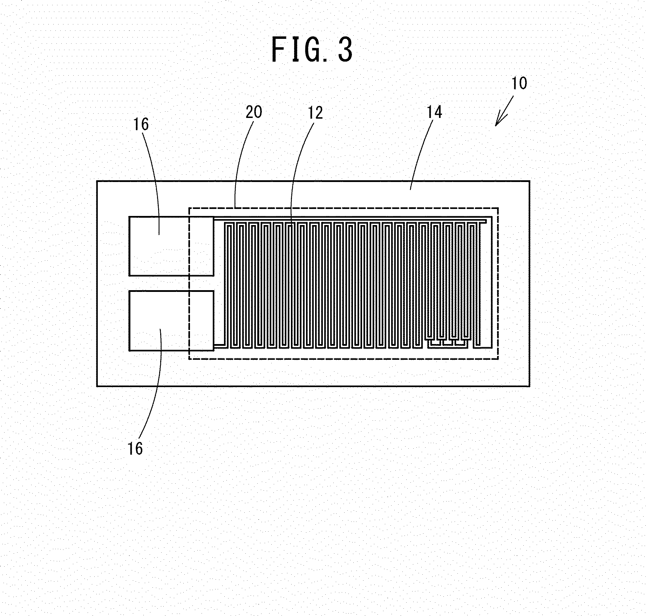

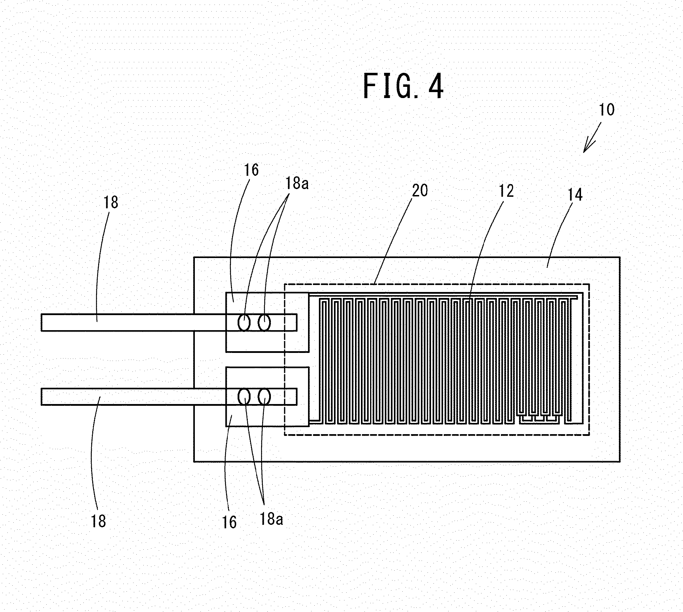

Hereinafter, an embodiment of the present invention will be described. Figs. 1 to 5 illustrate a thin film resistance element temperature sensor 10 of an embodiment of the present invention. In the thin film resistance element temperature sensor 10, resistance elements 12 consisting of a platinum thin film are formed, for example, on an insulating substrate 14 made of ceramic, such as alumina. As the insulating substrate 14, a high purity alumina ceramic substrate in which no impurities deposit even after the substrate is sintered is used. Further, since a high purity alumina ceramic substrate has high hardness, is not easily machined and is high in cost, a general alumina ceramic substrate having purity of about 96% may also be used. In this case, since Mg, Ca, Na and the like which are impurities in the alumina ceramic substrate deposit in the resistance element 12 and cause electrical resistance to increase, it is desirable to cover a surface of the insulating substrate 14 with an unillustrated undercoat film. The undercoat film is formed by coating high purity sol state alumina or magnesia.

An electrode pad 16 is stacked on each of a pair of connecting ends 12a of the resistance element 12. A pair of lead terminals 18 are connected to the electrode pads 16. The electrode pad 16 is formed using a pasted conductive paint which includes at least one of Ag, Pd, Pt and Au.

A barrier layer 20 consisting of crystallized glass is stacked on the resistance element 12 and a part of the pair of electrode pads 16 on the side of the resistance element 12. A component of the barrier layer 20 should be a material having alumina as a main component and having the same main component as that of the insulating substrate 14 which serves as a base. Further, a constituent ratio of the material includes 35% or greater of alumina (Al₂O₃), CaAl₂O₄ or a spinel structure of CaAl₂O₄, or a compound thereof, and other Al-Ca-Ba based material component. In this material, crystal having negative thermal expansion coefficient (for example, P-Ca-Ox, Si) is distributed in glass and thermal expansion that the glass has is cancelled by the negative thermal expansion of the crystal, and thus thermal expansion of the barrier layer 20 caused by a temperature change is relieved.

In particular, the component of the barrier layer 20 is, for example, an Al₂O₃-ZnO-SiO₂-CaO-BaO based material, an Al₂O₃-ZnO-SiO₂-SrO-BaO based material or a composite material thereof. Further, the component may also include CaAl₂O₄, SrAl₂O₄, spinel structure oxide of CaAl₂O₄ or spinel structure oxide of SrAl₂O₄. Note that, although the spinel structure oxides in which the oxide of Al, Ca and Sr which are materials described above have been substituted, with the crystal structure being partially changed, the final composition is not changed.

The tolerance of these components is as follows. Regarding Al₂O₃, 35% by mass to 80% by mass, desirably 35% by mass to 50% by mass. Regarding SiO₂, 10% by mass to 25% by mass, desirably 15% by mass to 20% by mass, and Al₂O₃>(CaO or SrO and other oxide components of Ba, Zn and P). In a case in which an amount of Si (the mass of SiO₂) is smaller than 10% by mass, there is a problem that it is difficult to form a glass film and, in a case in which the amount of Si is greater than 25% by mass, there is problem that resistance change ΔR becomes large.

A protective film 22 is further stacked on a surface of the barrier layer 20. The protective film 22 consists of, for example, Si-Ba-Al-Zr based glass ceramic (mass ratio: about 50:20:10:10), Si-Ca-Al-Ba-Sr based glass ceramic (mass ratio: about 50:20:10:10:5), other alumina (Al₂O₃), or quartz (SiO₂) glass ceramic. The protective film 22 covers the barrier layer 20 and welded portions 18a which are base ends of the electrode pads 16 and the lead terminals 18.

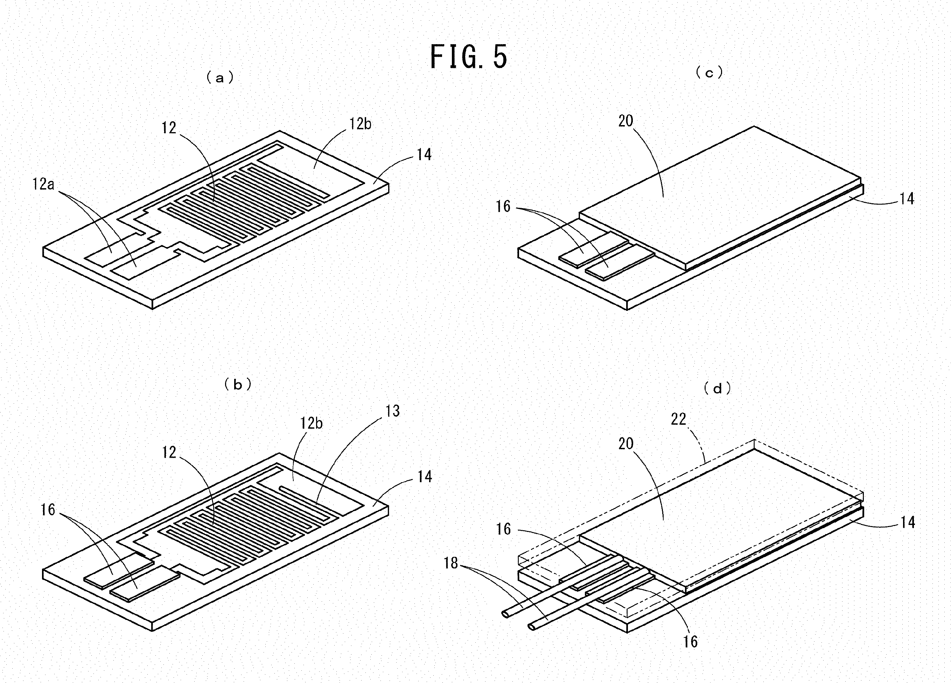

Next, a method for producing of the thin film resistance element temperature sensor 10 of the present embodiment will be described with reference to Fig. 5. First, using a large-sized ceramic substrate in which slits for dividing into the shape of individual insulating substrate 14 are formed, resist for patterning is applied to a surface of the substrate, and a pattern of the resistance element 12 is exposed and developed to form the pattern of the resistance element 12. Then, a platinum thin film is formed on a surface of the insulating substrate 14. The platinum thin film is formed as a uniform thin film on the insulating substrate 14 by a vacuum film formation method, such as vapor deposition and sputtering. Then, the platinum thin film is lifted off and, as illustrated in Fig. 5(a), the pattern of the resistance element 12 is formed by the platinum thin film on the surface of the insulating substrate 14.

Next, as illustrated in Fig. 5(b), the electrode pads 16 for connecting the lead terminals 18 are formed at the connecting ends 12a of the resistance element 12 by thick film printing, and then heat treatment is performed. An unillustrated mask having openings of the shape of the electrode pads 16 is used during the thick film printing. The heat treatment is performed at a constant high temperature of about 950°C to 1050°C, desirably at about 1000°C, to stabilize a grain boundary of the platinum thin film of the resistance element 12. Then, heat treatment is further performed in a high temperature region of 950°C to 1050°C, desirably at about 1000°C, and then annealing is performed, whereby a drift in the electrical property of the platinum thin film during processing in subsequent processes is reduced.

Further, as illustrated in Fig. 5(b), in order to regulate the resistance element 12 of the platinum thin film to a predetermined resistance value, a trimming groove 13 is formed in an adjusting portion 12b of the resistance element 12 by laser trimming.

Then, a paste consisting of a material of the barrier layer 20 which is crystallized glass is applied to the resistance element 12 of the platinum thin film using an unillustrated mask of the shape having an opening in the resistance element 12 and a part of the electrode pads 16 of the connecting ends 12a. It is desirable that this mask is used also as a masking mask of a pad section. After application and formation of the barrier layer material using the mask, heat treatment is performed at the temperature of about 1100°C to 1200°C to form the barrier layer 20.

After formation of the barrier layer 20, the large-sized ceramic substrate is divided into rectangular plates. Division is performed in a direction in which a plurality of pairs of electrode pads 16 are arranged adjacent to one another laterally in a line. Then, the lead terminals 18 are welded to the electrode pads 16. Welding is performed by forming welded portions 18a at plural locations in each lead terminal 18 by, for example, spot welding. At this time, end portions of the lead terminals 18 are located close to, and desirably located to overlap, an edge of the barrier layer 20.

Then, glass ceramic paste for the protective film 22 is applied so as to cover the barrier layer 20 using a predetermined mask having an opening of the size that the barrier layer 20 is covered. Further, the welded portions 18a are covered with the glass ceramic paste for the protective film 22 by, for example, dispensing so that portions at which the electrode pads 16 and the lead terminals 18 are welded together are covered. Then, sintering is performed so that connecting portions of the electrode pads 16 and the lead terminals 18 are covered with the protective film 22. Then the glass ceramic paste is heat-treated at the temperature of about 1100°C to 1200°C to form the protective film 22.

After the heat treatment, the rectangular substrate is further divided into individual insulating substrate 14 to produce individual thin film resistance element temperature sensor 10.

Since a dense material consisting of glass ceramic is used as the protective film 22 in the thin film resistance element temperature sensor 10 of the present embodiment, the thin film resistance element temperature sensor 10 can withstand the use in a high-temperature environment of 1000°C to 1200°C and withstand a sudden temperature change. Further, since the thin film resistance element temperature sensor 10 is equipped with the barrier layer 20 consisting of crystallized glass with reduced thermal expansion as an underlayer of the protective film 22, with respect to the thermal expansion of the protective film 22 caused by a sudden temperature change, an influence of distortion on the resistance element 12 can be reduced and an influence on the resistance element 12 caused by contaminants in the external environment, such as impurities and gas molecules, that may possibly enter from a crack produced in the protective film 22 can be reduced. Further, gas poisoning caused by the use in an exhaust gas environment of automobiles (entrance of a sulfur component in gasoline and the like) or contamination by Si (silicon) existing in, for example, a sealing agent of an internal combustion engine can be prevented by the barrier layer 20.

The contaminants which are these gas components will react on contact with the platinum resistance element 12 and the contaminants are positively absorbed and react by a catalytic effect of platinum, whereby sensor performance is impaired. Further, there is a possibility that thermal dissociation of silicon dioxide in the protective layer 22 is performed by an activating effect of platinum to form platinum and a compound, whereby sensor performance is impaired. The barrier layer 20 prevents these contaminants from reaching and influencing the resistance element 12.

Even if contaminants enter the sensor through the protective film 22, alumina and zinc oxide which are the components of the barrier layer 20 positively absorb the contaminants and prevent the contaminants from reaching the resistance element 12.

With the mechanism described above, according to the thin film resistance element temperature sensor 10 of the present invention, temperature-resistance characteristic and durability of the sensor can be improved while a simple configuration and reduced cost are achieved.

Further, since the barrier layer 20 is formed to completely cover the platinum resistance element 12 and a part of the connecting terminals 12a thereof except for the portion of the welded portions of the electrode pads 16 with the lead terminals 18, the resistance element 12 is reliably protected against the contaminants from the outside. Moreover, since the barrier layer 20 is formed in a state of partially overlapping the electrode pads 16 and ends of the lead terminals 18 overlap the barrier layer 20, a glass component of the barrier layer 20 fuses and solidifies with heat of applied current at the time of welding, whereby connection strength at the portion is increased and connection strength between the lead terminals 18 and the electrode pads 16 is also increased. With this, connection strength of the lead terminals of the sensor is increased, occurrence of connection failure of the lead terminals 18 can be reduced, and influences on the processing and line operation after the welding process can be significantly reduced.

Since the barrier layer 20 is formed, a drift in the resistance value of the resistance element 12 at the time of formation of the electrode pads 16 or other heat treatment can be reduced to the minimum. Further, it is also possible to form the barrier layer 20 only in a portion except for a trimming location before trimming treatment, to perform more accurate trimming, and to improve measurement accuracy.

Note that the thin film resistance element temperature sensor of the present invention is not limited to the embodiment described above: the pattern shape of the resistance element and the shape, thickness and the like of the barrier layer can be set suitably. The component and the number of layers of the protective film can also be set suitably.

### [Examples]

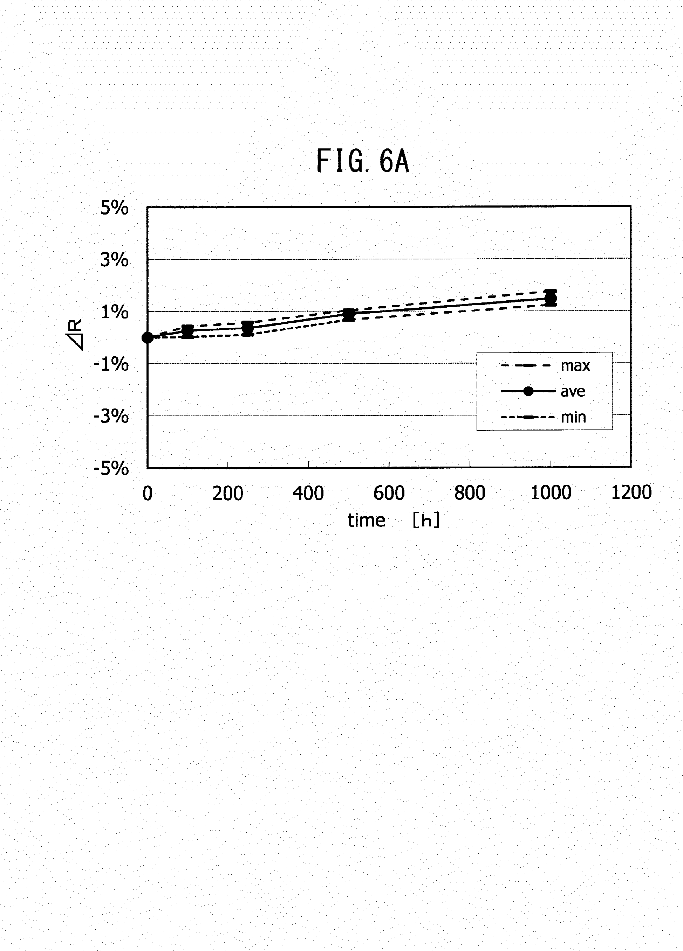

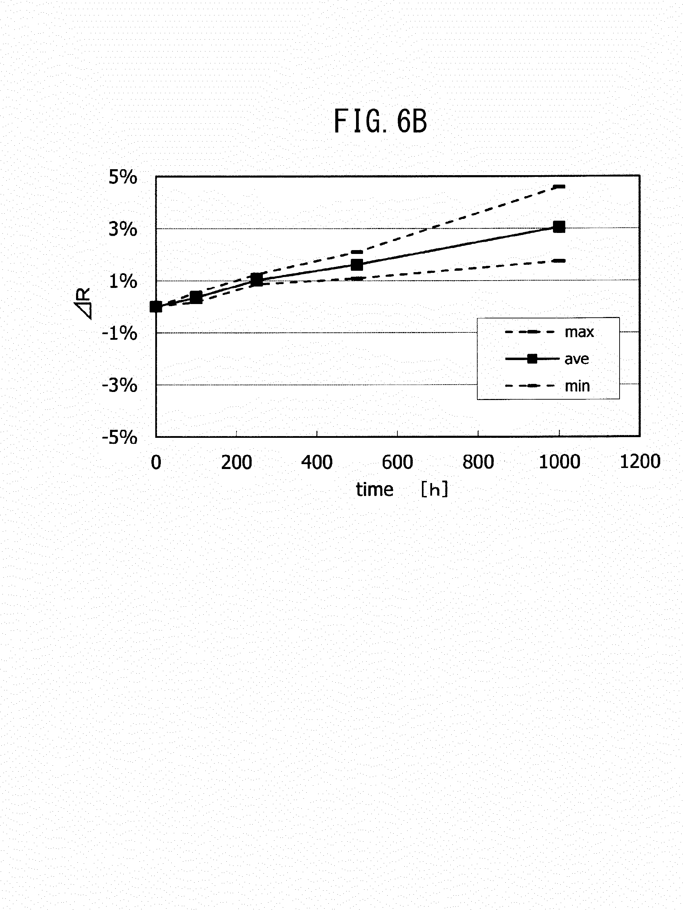

Next, results of performance tests of the thin film resistance element temperature sensor of the present invention will be described. Fig. 6 illustrates a result of a 1000°C aging durability test by a finished product of the thin film resistance element temperature sensor in which Al₂O₃-ZnO-SiO₂-CaO-BaO based crystallized glass (Al₂O₃: about 50% by mass, SiO₂: about 20% by mass) is used as the barrier layer 20. As illustrated in Fig. 6A, in the case of the sensor of this example, the resistance change ΔR is small even after 1000 hours and there is almost no variation. As illustrated in Fig. 6B, however, in the same test using a related art element (of which barrier layer is oxidized aluminum ceramic), resistance change ΔR becomes larger and variation thereof also becomes larger with time.

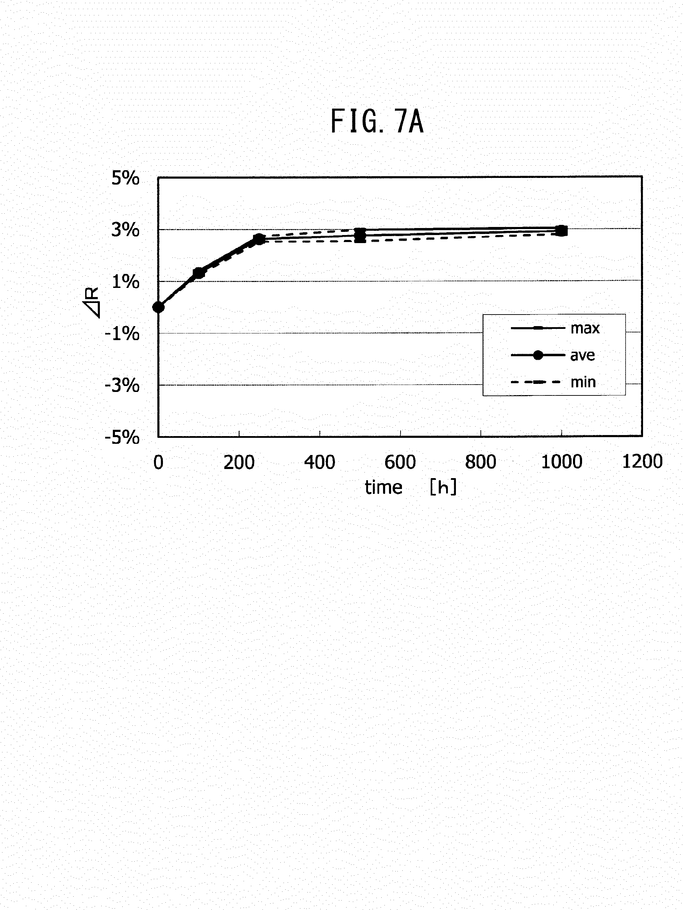

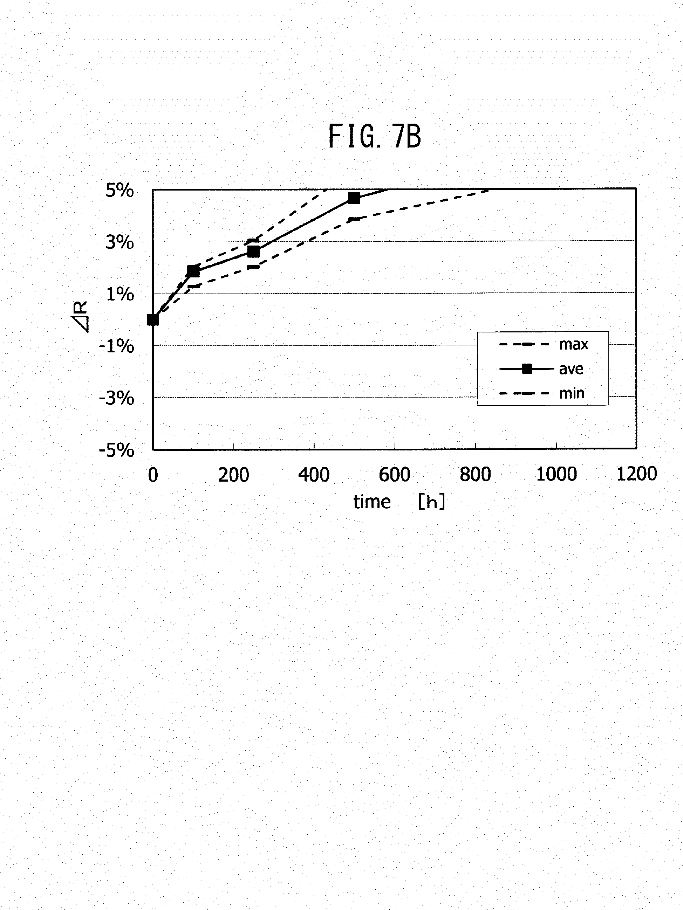

Further, a result of a performance test of the thin film resistance element temperature sensor in which only the barrier layer 20 before forming the protective film 22 is provided is illustrated in Fig. 7. A 100°C aging durability test in this case is performed. As illustrated in Fig. 7A, in the case of the sensor of the example of the present invention, the resistance change ΔR is within 3% even after 1000 hours. In the case of an element of a conventional example without a protective film, however, as illustrated in Fig. 7B, the resistance change ΔR becomes larger and variation also becomes larger with time.

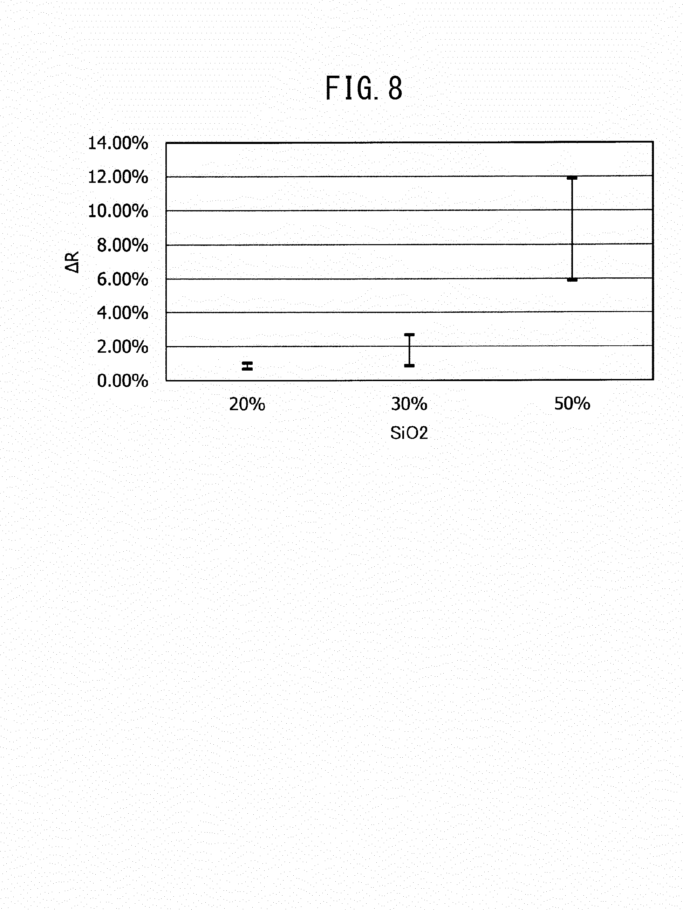

Next, a result of performance evaluation regarding an Si blending amount (an SiO₂ blending ratio) in a barrier layer is illustrated in Fig. 8. An amount of resistance change ΔR is an amount of change at 1000°C at 1000 hours. From this, since the optimum amount of Si (SiO₂) is 10% by mass to 25% by mass (the blending amount of Al₂O₃ at that time is 35% by mass or greater) and there is a problem that, if the amount of Si is smaller than 10% by mass, it is difficult to form a glass film, and the resistance change ΔR becomes larger when the amount of Si is 30% by mass, it has been confirmed that it is not desirable if 25% by mass is exceeded.

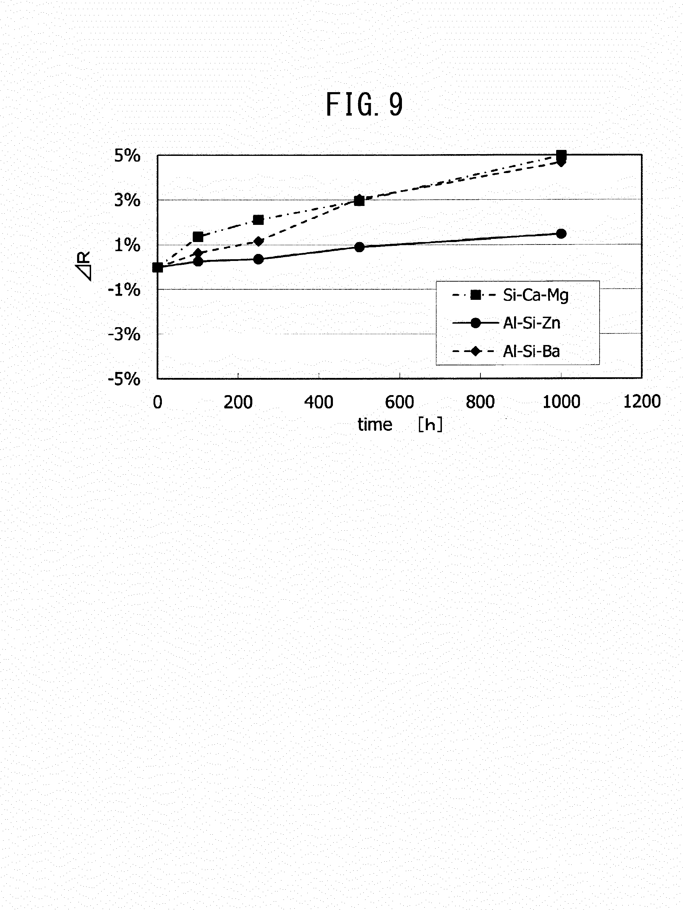

Next, regarding an effect of the Al and Zn components in the barrier layer 20 (which selectively react with a toxic substance (Si)=a catalytic effect), changes in the resistance change ΔR of a product in which a barrier layer of Al-Si-Zn based crystallized glass (mass ratio: 50:15:20 (other components: 15)) of the invention of this application is formed and products in which a barrier layer of Al-Si-Ba based crystallized glass (mass ratio: 30:20:30 (other components: 20)) is formed and in which a barrier layer of Si-Ca-Mg based crystallized glass (mass ratio: 50:20:15 (other components: 15)) is formed, both of which are outside the ratio of the invention of this application, are illustrated in Fig. 9.

It has been turned out that, in the case of the Al-Si-Zn based crystallized glass, the change in the resistance change ΔR is controlled to about 1% even after 1000 hours elapsed, but in the case of other components, the resistance change ΔR has become larger. Note that a ratio of ZnO is desirably 3% to 15%. This is because, if the ratio exceeds 20% by mass, glass is softened and the temperature-resistance characteristic is impaired.

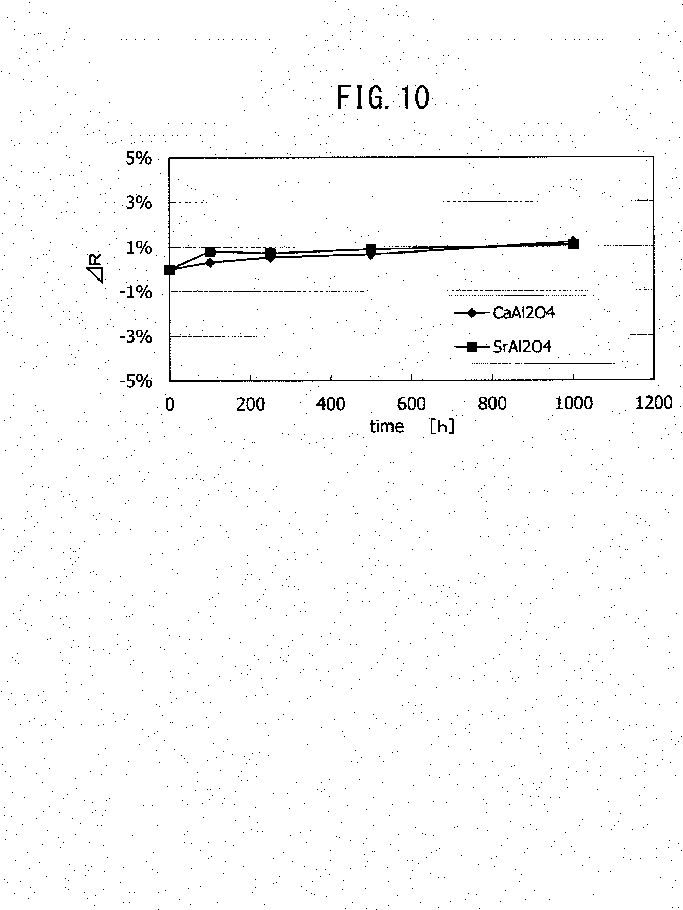

Next, changes in the resistance change ΔR regarding products which include composite spinel oxides (a CaAl₂O₄ compound, an SrAl₂O₄ compound) as composite components in the barrier layer 20 are illustrated in Fig. 10.

It has been turned out that changes in the resistance change ΔR of the thin film resistance element temperature sensor in which the barrier layer 20 of these components is provided are controlled to about 1% even after 1000 hours elapsed.

### DESCRIPTION OF REFERENCE NUMERALS

- 10: thin film resistance element temperature sensor
- 12: resistance element
- 14: insulating substrate
- 16: electrode pad
- 18: lead terminal
- 20: barrier layer
- 22: protective film

## Claims

1. A thin film resistance element temperature sensor, comprising:
a resistance element formed by a platinum thin film on an insulating substrate;
a barrier layer consisting of crystallized glass which covers the resistance element;
a protective film which covers the barrier layer; and
electrode pads stacked on connecting ends at both ends of the resistance element,
wherein the barrier layer consists of crystallized glass in which Al₂O₃ exists at a blending ratio of 35% by mass or greater, SiO₂ exists at a blending ratio of 10% by mass or greater to 25% by mass or less, and the blending ratio Al₂O₃ is greater than that of CaO or SrO.

2. The thin film resistance element temperature sensor according to claim 1, wherein the blending ratio of Al₂O₃ in the barrier layer is 35% by mass or greater to 50% by mass or less.

3. The thin film resistance element temperature sensor according to claim 1, wherein the blending ratio of SiO₂ in the barrier layer is 15% by mass or greater to 20% by mass or less.

4. The thin film resistance element temperature sensor according to claim 1, 2 or 3, wherein the barrier layer is stacked to cover the resistance element and a part of the electrode pads on the side of the resistance element.

5. The thin film resistance element temperature sensor according to claim 1, 2 or 3, wherein the barrier layer is a material consisting of a component of each oxide of Al₂O₃-ZnO-SiO₂-CaO-BaO.

6. The thin film resistance element temperature sensor according to claim 1, 2 or 3, wherein the barrier layer is a material consisting of each oxide of Al₂O₃-ZnO-SiO₂-SrO-BaO.

7. The thin film resistance element temperature sensor according to claim 5, wherein the barrier layer includes spinel structure oxide of CaAl₂O₄.

8. The thin film resistance element temperature sensor according to claim 6, wherein the barrier layer includes spinel structure oxide of SrAl₂O₄.

9. The thin film resistance element temperature sensor according to claim 4, wherein
the protective film consists of Si-Ba-Al-Zr based glass ceramic and covers the barrier layer, the electrode pads and base ends of lead terminals connected to the electrode pads.

10. The thin film resistance element temperature sensor according to claim 9, wherein a mass ratio of each component of the Si-Ba-Al-Zr based glass ceramic of the protective film is 5:2:1:1: (other components 1).

11. A method for producing a thin film resistance element temperature sensor, comprising:
forming a resistance element by a platinum thin film on an insulating substrate;
applying, to the resistance element, material paste of crystallized glass in which Al₂O₃ exists at a blending ratio of 35% by mass or greater, SiO₂ exists at a blending ratio of 10% by mass or greater to 25% by mass or less, and the blending ratio Al₂O₃ is greater than that of CaO or SrO, and then performing heat treatment;
covering the resistance element with the crystallized glass to form a barrier layer;
applying an electrode pad material to connecting ends of the resistance element and performing heat treatment to form electrode pads;
connecting lead terminals to the electrode pads; and
applying material paste of a protective film to cover the barrier layer and the electrode pads and performing heat treatment to form the protective film on the barrier layer.

12. The method for producing the thin film resistance element temperature sensor according to claim 11,
further comprising performing trimming to adjust a resistance value of the resistance element before formation of the barrier layer.

13. The method for producing the thin film resistance element temperature sensor according to claim 11, wherein
the barrier layer is formed except for a trimming location of the resistance element and trimming is performed to adjust a resistance value of the resistance element after formation of the barrier layer.

14. The method for producing the thin film resistance element temperature sensor according to claim 11, wherein
the lead terminals are connected to the electrode pads by welding, and a glass component of the barrier layer in an area near the lead terminals fuses with heat at the time of the welding and then solidifies to increase connection strength of that portion.
